(19) Europäisches Patentamt
European Patent Office
Office européen des brevets

(11) Publication number: **0 031 671**
**B1**

(12) **EUROPEAN PATENT SPECIFICATION**

(45) Date of publication of patent specification: **31.10.84**

(21) Application number: **80304550.9**

(22) Date of filing: **17.12.80**

(51) Int. Cl.[3]: **H 01 L 21/225,**
H 01 L 21/316, C 23 C 11/08

(54) **A method of growing silicate glass layers employing a chemical vapour deposition process.**

(30) Priority: **28.12.79 JP 171068/79**

(43) Date of publication of application:
**08.07.81 Bulletin 81/27**

(45) Publication of the grant of the patent:
**31.10.84 Bulletin 84/44**

(84) Designated Contracting States:
**DE FR GB NL**

(56) References cited:
**DE-A-2 723 500**
**US-A-3 934 060**
**US-A-4 098 923**

**SOLID STATE TECHNOLOGY, vol. 20, no. 4, April 1977, (US), R. ROSLER: "Low Pressure CVD Production Processes for Poly, Nitride and Oxide", pages 63-70**
**IBM TECHNICAL DISCLOSURE BULLETIN, vol. 18, no. 7, December 1975, NEW YORK (US), R.E. CHAPPELON et al.: "Controlling Reaction Pressure in CVD Tools", pages 2082-2083**

(73) Proprietor: **FUJITSU LIMITED**
**1015, Kamikodanaka Nakahara-ku**
**Kawasaki-shi Kanagawa 211 (JP)**

(72) Inventor: **Shioya, Yoshimi**
**16-6-402, Namiki 1-chome Kanazawa-ku**
**Yokohama-shi Kanagawa 236 (JP)**
Inventor: **Takagi, Mikio**
**6-20-3, Nagao Tama-ku**
**Kawasaki-shi Kanagawa 213 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
**JOURNAL OF THE ELECTROCHEMICAL SOCIETY, vol. 117, no. 4, April 1970, (US), W. KERN et al.: "Chemical Vapor deposition of silicate glasses for use with silicon devices", pages 562-568**
**SOLID STATE TECHNOLOGY, vol. 18, no. 12, December 1975, (US), W. KERN: "Chemical Vapor Deposition Systems for Glass Passivation of Integrated Circuits", pages 25-33**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a method of growing silicate glass layers such as phospho-silicate glass layers (hereinafter referred to as PSG layers) on semiconductor substrates employing a chemical vapour deposition process. More particularly, this invention relates to an improvement of the method to enable the impurity concentration doped in the silicate glass to be made more uniform for all of the semiconductor substrates processed in one batch at the same time.

It is widely known that a sealed tube made usually, but not necessarily always, of quartz or stainless steel is usually employed for growing silicate glass layers such as PSG layers on semiconductor substrates employing a chemical vapour deposition process. The sealed tube may be provided with an electric heater which surrounds the sealed tube to heat the semiconductor substrates placed therein, one inlet at one end of the sealed tube, a second inlet at the same one end of the sealed tube or distributed along the semiconductor substrates placed therein, one outlet at the other end of the sealed tube, and a vacuum pump which causes reactive gases to flow inside the sealed tube at a specific low pressure. When the chemical vapour deposition process is put into operation, the vacuum pump is operated to cause the reactive gases containing silane ($SiH_4$), phosphine ($PH_3$) and oxygen ($O_2$) to flow into the sealed tube through the inlets and to flow out of the sealed tube through the outlet. The length of such a sealed tube is usually selected to be two meters and the intermediary portion, with a length of approximately 1 meter, of the sealed tube is usually kept at a uniform temperature by the heater. A plurality of semiconductor wafers are arranged on a wafer holder or boat placed in the uniform temperature zone of the sealed tube in a perpendicular or inclined position with respect to the axis of the tube, and in the transverse direction with respect to the tube. The reactive gases containing silane ($SiH_4$), phosphine ($PH_3$) and oxygen ($O_2$) flowing inside the sealed tube make chemical reaction in the neighbourhood of the semiconductor wafers to deposit PSG layers on each of the semiconductor wafers.

When growing PSG layers on each of the semiconductor wafers standing side by side in such a long sealed tube reactor, it is fairly difficult to make the conditions of the chemical vapour deposition process uniform at each location along the long tube. This of course causes an adverse effect for the uniform impurity concentration doped in PSG grown by the process. Needless to emphasize, it is extremely important or desirable to make the impurity of phosphorus concentration, doped in PSG, uniform for all of the wafers processed in one batch.

In reality, however, no effective methods were available in the prior art for making the impurity or phosphorus concentration doped in PSG uniform for all of the plurality of semiconductor wafers aligned along the flow of the reactive gases but in the transverse direction to the flow of the reactive gases. Therefore, an inefficient but practical method was employed to make the impurity of phosphorus concentration doped in PSG uniform for all the wafers processed in one batch at the same time. Namely, conditions optimum for making the impurity of phosphorus concentration uniform for all the wafers were determined, on a trial and error basis, by repetition of trials made with varied parameters such as the temperature, the quantity of gas supplied for the reaction, the quantity of substrates processed in one batch, and the shape and length of the sealed tube. It is clear that this trial-and-error-type method is inevitably involved with inefficiency, incorrectness, longer time consumption and inconvenience.

U.S—A—4 098 923 describes apparatus for depositing silicon dioxide pyrolytically by the reaction of silane and oxygen on vertically mounted substrates in an evacuated system. A standard diffusion furnace equipped with a furnace tube which is vacuum tight is used. Injection tubes having multiple injection ports are positioned within the furnace tube to distribute the silane and the oxygen uniformly across a plurality of substrates which are positioned perpendicular to the furnace tube axis and which are covered with perforated shroud. A vacuum pump is used to evacuate the furnace tube. Supply of oxygen and silane is controlled by flow meters.

Solid State technology, Vo. 20, No. 4, April 1977, in an article by Rosler entitled "Low Pressure CVD Production Processes for Poly, Nitride and Oxide" on pages 63 to 70, discloses the chemical vapour deposition of silicate glass layers on a plurality of semiconductor wafers, employing a sealed tube with inlets and an outlet arranged on the sealed tube for allowing reactive gases to flow in and out of the sealed tube. A vacuum pump is used to cause the reactive gases to flow in the sealed tube to allow those gases to chemically react in the neighbourhood of the semiconductor wafer. The wafers are held perpendicularly (shown to be inclined in Figure 3) in the tube and are spaced apart at intervals. The flow of reactive gases is regulated to control the deposition process.

According to the present invention there is provided a method of chemical vapour deposition for growing silicate glass layers on a plurality of semiconductor wafers, employing a sealed tube, inlets and an outlet arranged on said sealed tube for allowing reactive gases to flow in and out of said sealed tube, and a vacuum pump to cause said reactive gases to flow in said sealed tube to allow said reactive gases to make chemical reaction in the neighbourhood

of said plurality of semiconductor wafers, the wafers being aligned transversely with respect to said tube such that they are perpendicular to, or inclined with respect to, the axis of said tube, and being spaced apart at predetermined intervals, comprising regulating the supply of said reactive gases, characterised in that the flow rate of said reactive gases, in terms of gas velocity at a position between the periphery of a first one of said plurality of semiconductor wafers and the adjacent internal surface of the sealed tube in the direction of gas flow in said tube is regulated to fall within the range 6 m/sec to 12 m/sec by employing pressure monitoring means, arranged for monitoring internal pressure of said sealed tube, which means are calibrated in advance to indicate flow rate in terms of such gas velocity of non-reactive gas.

According to the present invention there is also provided a method of chemical vapour deposition for growing silicate glass layers on a plurality of semiconductors wafers, employing a sealed tube, inlets and an outlet arranged on said sealed tube for allowing reactive gases to flow in and out of said sealed tube, and a vacuum pump to cause said reactive gases to flow in said sealed tube to allow said reactive gases to make chemical reaction in the neighbourhood of said plurality of semiconductor wafers, the wafers being aligned transversely with respect to said tube such that they are perpendicular to, or inclined with respect to, the axis of said tube, and being spaced apart at predetermined intervals, comprising regulating the supply of said reactive gases, characterised by the following steps:—

(a) arranging the plurality of semiconductor wafers in the sealed tube, aligned transversely with respect to said tube such that they are perpendicular to, or inclined with respect to, the axis of said tube, and spaced apart at predetermined intervals;

(b) flowing nonreactive gas into and out of sealed tube through inlets and an outlet arranged on the sealed tube and using a vacuum pump to cause the nonreactive gas to flow through the sealed tube;

(c) calibrating pressure monitoring means, provided on said tube for monitoring the internal pressure of said tube, to indicate flow rate in terms of gas velocity at a position between the periphery of a first one of said plurality of semiconductor wafers and the adjacent internal surface of the sealed tube in the direction of gas flow in said tube of the non-reactive gas;

(d) flowing reactive gases into and out of the sealed tube through the inlets and outlet arranged on the sealed tube and using a vacuum pump to cause the reactive gases to make chemical reaction of the neighbourhood of the plurality of semiconductor wafers,

(e) regulating gas velocity of said reactive gases as indicated by the pressure monitoring means to fall within the range 6 m/sec to 12 m/sec, for obtaining uniform deposition of silicate glass to be formed on said plurality of semiconductor wafers.

A preferred method according to the invention provides a method of growing silicate glass layers, for example PSG layers, on semiconductor wafers based on a chemical vapour deposition process employing a sealed tube made of quartz or stainless steel which is provided with a heater surrounding the sealed tube, inlets and an outlet for reactive gases and a vacuum pump which causes the reactive gases to flow inside the sealed tube to make chemical reaction in the neighbourhood for the semiconductor wafers aligned side by side in the uniform temperature zone in the sealed tube, the improvement being to enable the impurity or phosphorus concentration doped for example in PSG to be made substantially uniform for all the semiconductor wafers processed in one batch at the same time.

We have discovered that the flow i.e. gas velocity rate of the reactive gases flowing inside the sealed tube is more determinative, out of the various parameters, to the impurity or phosphorus concentration doped in PSG, and that it is effective for making the impurity or phosphorus concentration doped in PSG substantially uniform for all the semiconductor wafers processed in the same sealed tube at the same time, to maintain the flow rate of the reactive gases at a rate which is effective to cause a uniform quantity of the reactive gases to contact with each semiconductor wafer. After a number of experiments carried out to prove the concept mentioned above, we have determined that a particular specification of an equipment employed for the process and a specific process condition readily determine an optimum flow rate of the reactive gases for making the impurity or phosphorus concentration doped in PSG substantially uniform for all the semiconductor wafers processed at the same time, and that it is readily possible to maintain the flow rate i.e. gas velocity of the reactive gases in the neighbourhood of the wafers at the optimum flow rate by regulating the gas pressure by monitoring the readings of a manometer which is arranged in the neighbourhood of the inlet of the reactive gases and is calibrated to represent the flow rate of nitrogen ($N_2$) gas.

We have further determined that the optimum flow rate of the reactive gases can be selected from the manometer reading range which represents the nitrogen ($N_2$) gas flow rate range of 6 to 12 m/sec. calibrated as mentioned above, according to the geometrical and/or process-wise conditions of a specific equipment and a process employed.

It is noted that the arrangement of inlets may have a variety of forms. All of the inlets may be provided at one end of the sealed tube.

Incidentally, however, in order to supply some of the reactive gases, for example oxygen ($O_2$), uniformly to all the semiconductor wafers, the inlet for such gases may be distributed along the semiconductor wafers. This latter inlet arrangement is readily realized by placing one or more long inlet tubes which has or have a number of holes therein along the semiconductor wafers. Such gases, for example oxygen ($O_2$), flow into the sealed tube through the number of holes provided on the long tube or tubes.

For a better understanding of the invention and to show how it may be put into effect reference will now be made, by way of example, to the accompanying drawings, in which:

Fig. 1 shows a schematic longitudinal cross-sectional view of an equipment for chemical vapour deposition;

Fig. 2 shows a transverse cross-sectional view of the equipment for chemical vapour deposition, taken along section lines X—X in Fig. 1; and

Fig. 3 is a graph of sheet resistance representing phosphorous concentration, versus wafer position in a sealed tube.

With reference to Figs. 1 and 2, an equipment for a chemical vapour deposition process employed for growing silicate glass layers, such as PSG layers, comprises a sealed tube 1 made of quartz or stainless steel in which a plurality of semiconductor wafers 2 are arranged on a wafer holder or a boat 3 placed inside the sealed tube 1. The arrangement of the semiconductor wafers 2 is made in the vertical or inclined position and in the transverse direction with respect to the sealed tube 1, usually at uniform intervals along the sealed tube 1 within a uniform temperature zone heated by an electric heater 7 surrounding the sealed tube 1. Reactive gases containing silane ($SiH_4$), and phosphine ($PH_3$) flow into the sealed tube 1 through an inlet 4, and oxygen ($O_2$) flows into the sealed tube 1 through an inlet 5.

As mentioned above, one or more inlets for oxygen ($O_2$) can be arranged with some intervals on one or more long tubes placed inside the sealed tube 1 and along the array of the wafers 2.

A vacuum pump 6 is employed to cause the gases to flow inside the sealed tube 1. A manometer 8 is arranged to monitor the internal pressure of the sealed tube 1.

When the above-mentioned gases are supplied in the neighbourhood of the semiconductor wafers 2 heated at a temperature of approximately 450°C, the following reactions occur to deposit PSG which is a mixture of silicon dioxide ($SiO_2$) and phosphorus pentoxide ($P_2O_5$) on the semiconductor wafers 2:

$$SiH_4+O_2=SiO_2+2H_2$$

$$4PH_3+7O_2=2P_2O_5+4H_2O+2H_2$$

We assumed that supply of a uniform quantity of the reactive gases to each wafer 2 would be essential for making the impurity of phosphorus concentration doped in PSG uniform for all the semiconductor wafers 2 processed in the same sealed tube 1 at the same time. Further, we assumed that regulation of the flow rate of the reactive gases in the neighbourhood of the semiconductor wafers 2 could be effective to supply the uniform quantity of the reactive gases to all the semiconductor wafers 2.

In order to prove the concepts which we assumed would be effective for making the impurity or phosphorus concentration doped in PSG uniform for all the semiconductor wafers 2, we carried out two different groups of experiments employing 2 different sealed tubes.

For the first group of experiments, we employed a quartz sealed tube 1 with a diameter of 103 mm, in which 30 sheets of semiconductor wafers 2 with a diameter of 7.6 cm (3 inches) were aligned side by side at approximately 3 cm uniform intervals on the boat 3 placed in the intermediate portion of the sealed tube 1, at which the internal temperature is kept at approximately 450°C by the heater 7, as shown in Figs. 1 and 2.

For the second groups of experiments, we employed a quartz sealed tube 1 with a diameter of 123 mm, in which 110 sheets of semiconductor wafers 2 with a diameter of 10.2 cm (4 inches) were so aligned that a pair of wafers is arranged back to back with 3 mm spacing and each pair is arranged at 1.5 cm uniform intervals on the boat 3 placed in the uniform temperature zone at which the internal temperature is kept at 425°C.

For the purpose to acquire a reference for regulation of flow rate of the reactive gases at the area 1a which is close to the first one of the aligned semiconductor wafers 2, nitrogen gas ($N_2$) was flowed into the sealed tube 1 through the inlet 4 at various flow rates which were regulated by means of the vacuum pump 6, before the manometer 8 was read. This procedure was carried out to calibrate the reading of the manometer 8 corresponding to a specific flow rate of the nitrogen gas at the area 1a inside the sealed tube 1.

More specifically, the readings of the manometer 8 were detected corresponding to the various flow rates of nitrogen ($N_2$) gas which were detected by reading a mass flow meter arranged on the inlet 4, in order to utilize the readings of the manometer 8 to detect the flow rate of the reactive gases thereafter.

The physical principles of this procedure will be discussed below. Assigning v to the flow rate of a non reactive gas such as nitrogen, S to the cross-sectional area through which the gas flows, and V to the volume of the gas flowing during unit time the following formula is affirmed.

$$v=V/S \qquad (1)$$

When this formula (1) is applied to the equipment shown in Figs. 1 and 2, the cross-sectional area S corresponds to the area which is the internal cross-sectional area of the sealed tube 1 less the cross-sectional area of a semiconductor wafer 2, disregarding the cross-sectional area of the boat 3.

On the other hand, the volume of the gas flowing during the unit time, V, can be shown to depend on the expression

$$PV/T=PoVo/To \quad (2)$$

wherein:

P is the internal pressure of the sealed tube 1;

T is the internal temperature of the sealed tube 1;

Po is the pressure of the gas prior to flowing into the sealed tube 1;

To is the temperature of the gas prior to flowing into the sealed tube 1; and

Vo is the volume of the gas which has flowed during the unit time prior to flowing into the sealed tube 1.

Therefore, combining these formulae (1) and (2), the flow rate (gas velocity) of the gas v is shown to be:

$$v=PoVoT/PSTo \quad (3)$$

Accordingly, arbitrary flow rate can be realized for any non reactive gas by adjusting the right side of the formula (3). Therefore, adjustment of the internal pressure of the sealed tube 1 by means of the vacuum pump 6 can readily realize the flow rate for any non-reactive gas.

The reason why the area 1a is chosen which is between the circular edge of the first one of the aligned semiconductor wafers 2 and the internal surface of the sealed tube 1 is that we considered the above mentioned chemical reactions have scarcely occurred before the reactive gases reach this area 1a, resulting in that the flow rate of the reactive gases and the non-reactive nitrogen ($N_2$) gas are close with each other in this area 1a.

The reference which is the reading of the manometer 8 was employed for both groups of experiments to assume the flow rate of the reactive gases at the area 1a which is close to the first one of the aligned plural semiconductor wafers 2, as already mentioned.

Thereafter, for the first group of experiments, the reactive gases containing silane ($SiH_4$), phosphine ($PH_3$) and oxygen ($O_2$) were supplied at various flow rates to grow PSG layers with an approximate thickness of 10,000—15,000 angstroms on the semiconductor wafers 2. Since it is well-known that the relative composition of the reactive gases should be selected in accordance with the required specification of PSG, the experiments were carried out for a variety of relative compositions of the reactive gases, albeit the major interest was paid in the case in which the volumetric ratio of phosphine ($PH_3$) and silane ($SiH_4$) was 1:10. Incidentally, for the purpose of comparison, two types of heat treatment processes were applied to each case in which the flow rate was varied. The first was to keep the wafers 2 at 1,000°C for 20 minutes and the second was to keep the wafers 2 at 1,100°C for 20 minutes.

The results of the experiments are illustrated in graphs shown in Fig. 3, whose Y axis represents the sheet resistance $\rho s$ of each PSG layer, which resistance is believed to be an index representing the phosphorus concentration doped in the PSG layer, and whose X axis represents the corresponding wafer position in the sealed tube 1.

Firstly, Curve 1A shows the case in which the flow rate of the reactive gases, which was determined in the manner mentioned above, was 12 m/sec. (1.34 Torr as the reading of the manometer 8) and the heat treatment applied was the first type. Secondly, Curve 3A shows the case in which the flow rate of the reactive gases, which was determined in the manner mentioned above, was 22 m/sec. (96 Pa (0.72 Torr) as the reading of the manometer 8) and the heat treatment applied was the first type. The former curve 1a shows a better uniformity in the phosphorus concentration doped in PSG for each wafer 2 independently of the location of the wafer 2.

Thirdly, Curves 1B, 2B and 3B respectively show the cases in which the flow rates of the reactive gases, which were determined in the manner mentioned above, were respectively 12 m/sec 178 Pa (1.34 Torr) as the reading of the manometer 8), 17 m/sec 125 Pa (0.94 Torr) as the reading of the manometer 8), and 22 m/sec. 96 Pa (0.72 Torr) as the reading of the manometer 8) and the heat treatment applied was the second type. Although the tendency is less clear in these cases, the same tendency is observed also for these cases as for the former cases. In other words, the best uniformity in phosporus concentration doped in PSG for each wafer is observed for the reactive gases flow rate of 12 m/sec. which was detected in the manner mentioned above.

As described above, the results of the first group of experiments clearly show that the uniformity in phosphorus concentration doped in PSG for each of the semiconductor wafers 2 processed in one batch at the same time depends on the flow rate of the reactive gases, and that the reactive gases flow rate of 12 m/sec, which was determined in the manner mentioned above, shows the optimum condition for the above mentioned dimensional and chemical conditions.

A similar procedure to the above was employed and a similar tendency to the above was observed also for the second group of experiments. Out of the numerous results, only one optimum result is illustrated, as Curve 4C,

in Fig. 3. In this case the flow rate of the reactive gases, which was determined in the manner mentioned above, and the heat treatment conditions were: 8 m/sec 253 Pa (1.9 Torr) as the reading of the manometer 8) and 60 sec. at 1,150°C respectively.

Accordingly, we have determined that regulation of the flow rate range of the reactive gases (by the nitrogen flow rate assumed employing the readings of the manometer arranged in the neighbourhood of the inlets, the manometer being calibrated by the flow rate of nitrogen gas as mentioned above) to the range 6 to 12 m/sec. to be particularly effective for enabling the impurity of phosphorus concentration doped in PSG to be made uniform for all the semiconductor wafers processed in one batch at the same time, insofar as the presently available equipments for chemical vapour deposition with the above mentioned dimensional limitations and the above mentioned process-wise conditions are concerned.

As discussed earlier, it is clear that adjustment of the manometer's reading to 178 Pa (1.34 Torr) is effective to make the impurity or phosphorus concentration uniform for each of the semiconductor wafers processed in one batch, insofar as the vacuum vapour deposition equipment employed for the first group of experiments is concerned, regardless of the other parameters influencial to the uniformity of the impurity or phosphorus concentration.

It is needless to emphasize that the above mentioned dimensional limitations applied to the equipment for a chemical or vacuum vapour deposition process and the physical and chemical limitations applied to the process should not be construed as the reasonable limitations to determine the scope of this invention. In other words, a particular specification of an equipment employed for the process and specific processwise conditions readily determine an optimum flow rate of the reactive gases for making the impurity or phosphorus concentration doped in silicate glass uniform for all the semiconductor wafers processed at the same time.

In conclusion, in accordance with this invention, we have provided an efficient, correct, less time consuming and convenient method of growing silicate glass layers, for example PSG layers, in semiconductor wafers employing a chemical vapour deposition process, wherein the improvement is to enable the impurity or phosphorus concentration doped in the silicate glass to be made more uniform for all the semiconductor wafers processed in one batch at the same time.

Impurity concentration doped in PSG deposited on a plurality of semiconductor substrates 2 employing a chemical vapour deposition process depends on the flow rate of reactive gases in the neighbourhood 1a of the first one of the semiconductor substrates 2 processed with the same equipment in one batch at the same time. Regulation of the flow rate of the reactive gases in the neighbourhood of the first one of the semiconductor substrates processed with the same equipment in one batch at the same time is effective to make the impurity concentration doped in PSG uniform for all the semiconductor substrates processed in one batch employing the presently available sealed tube type equipment for vacuum vapour deposition process. The flow rate regulation is possible by monitoring readings of a manometer 8 which is arranged around the inlets 4, 5 of the tube and which was calibrated employing the flow rate of non-reactive gas such as nitrogen gas.

## Claims

1. A method of chemical vapour deposition for growing silicate glass layers on a plurality of semiconductor wafers, employing a sealed tube, inlets and an outlet arranged on said sealed tube for allowing reactive gases to flow in and out of said sealed tube, and a vacuum pump to cause said reactive gases to flow in said sealed tube to allow said reactive gases to make chemical reaction in the neighbourhood of said plurality of semiconductor wafers, the wafers being aligned transversely with respect to said tube such that they are perpendicular to, or inclined with respect to, the axis of said tube, and being spaced apart at predetermined intervals, comprising regulating the supply of said reactive gases, characterised in that the flow rate of said reactive gases, in terms of gas velocity at a position between the periphery of a first one of said plurality of semiconductor wafers and the adjacent internal surface of the sealed tube in the direction of gas flow in said tube is regulated to fall within the range 6 m/sec to 12 m/sec by employing pressure monitoring means, arranged for monitoring internal pressure of said sealed tube, which means are calibrated in advance to indicate flow rate in terms of such gas velocity of non-reactive gas.

2. A method of chemical vapour deposition for growing silicate glass layers on a plurality of semiconductor wafers, employing a sealed tube, inlets and an outlet arranged on said sealed tube for allowing reactive gases to flow in and out of said sealed tube, and a vacuum pump to cause said reactive gases to flow in said sealed tube to allow said reactive gases to make chemical reaction in the neighbourhood of said plurality of semiconductor wafers, the wafers being aligned transversely with respect to said tube such that they are perpendicular to, or inclined with respect to, the axis of said tube, and being spaced apart at predetermined intervals, comprising regulating the supply of said reactive gases, characterised by the following steps:—

(a) arranging the plurality of semiconductor

wafers in the sealed tube, aligned transversely with respect to said tube such that they are perpendicular to, or inclined with respect to, the axis of said tube, and spaced apart at predetermined intervals;

(b) flowing nonreactive gas into and out of the sealed tube through inlets and an outlet arranged on the sealed tube and using a vacuum pump to cause the nonreactive gas to flow through the sealed tube;

(c) calibrating pressure monitoring means, provided on said tube for monitoring the internal pressure of said tube, to indicate flow rate in terms of gas velocity at a position between the periphery of a first one of said plurality of semiconductor wafers and the adjacent internal surface of the sealed tube in the direction of gas flow in said tube of the nonreactive gas;

(d) flowing reactive gases into and out of the sealed tube through the inlets and outlet arranged on the sealed tube and using a vacuum pump to cause the reactive gases to make chemical reaction in the neighbourhood of the plurality of semiconductor wafers,

(e) regulating as velocity of said reactive gases as indicated by the pressure monitoring means to fall within the range 6 m/sec to 12 m/sec, for obtaining uniform deposition of silicate glass to be formed on said plurality of semiconductor wafers.

3. A method as claimed in claim 1 or 2, wherein said pressure monitoring means comprise a manometer on said tube in the neighbourhood of said inlets.

4. A method as claimed in any preceding claim, wherein the silicate glass is phosphosilicate glass.

5. A method as claimed in any preceding claim, wherein the internal pressure of said tube is adjusted by said vacuum pump to achieve a desired gas velocity of reactive gases.

6. A method as claimed in any preceding claim, wherein the said plurality of wafers are mounted within an internal uniform heated temperature zone maintained in said tube.

7. A method as claimed in any preceding claim, wherein at least one of the inlets arranged on said sealed tube is positioned along said plurality of semiconductor wafers.

8. A method as claimed in claim 7, wherein said at least one inlet carries oxygen as a reactive gas.

**Patentansprüche**

1. Verfahren zur chemischen Dampfabscheidung zum Aufwachsen von Silikatglassschichten auf einer Vielzahl von Halbleiter-Wafern, bei welchem ein versiegeltes Rohr verwendet wird, an welchem Einlässe und ein Auslaß angeordnet sind, um zu ermöglichen, daß reaktive Gase in das versiegelte Rohr hineinströmen und aus diesem herausströmen, und eine Vakuumpumpe, welche bewirkt, daß das reaktive Gas in das genannte versiegelte Rohr fließt, um zu erlauben, daß die reaktiven Gase eine chemische Reaktion in der Nähe der Vielzahl von Halbleiter-Wafern durchführen, welche quer bezüglich des genannten Rohres so angeordnet sind, daß sie senkrecht zu oder geneigt zu der Achse des genannten Rohres sind und unter vorbestimmten Abständen voneinander angeordnet sind, mit Regulierung der Zuführung der genannten reaktiven Gase, dadurch gekennzeichnet, daß der Durchfluß der reaktiven Gase in Termen von Gasgeschwindigkeit bei einer Position zwischen der Peripherie eines ersten der genannten vielen Halbleiter-Wafer und der angrenzenden inneren Oberfläche des versiegelten Rohres in der Richtung der Gasströmung in dem Rohr geregelt wird, um innerhalb der Bereiches von 6 m pro Sekunde bis 12 m pro Sekunde zu fallen, unter Verwendung einer Drucküberwachungseinrichtung, welche so angeordnet ist, daß sie den inneren Druck des versiegelten Rohres überwacht, und welche im voraus geeicht ist, um die Strömungsgeschwindigkeit in Termen von solch einer Gasgeschwindigkeit von nichtreaktivem Gas anzuzeigen.

2. Verfahren zur chemischen Dampfabscheidung zum Aufwachsen von Silikatglasschichten auf einer Vielzahl von Halbleiter-Wafern, bei welchem ein versiegeltes Rohr verwendet wird, an welchem Einlässe und ein Auslaß angeordnet sind, um zu ermöglichen, daß reaktive Gase in das versiegelte Rohr hineinströmen und aus diesem herausströmen, und eine Vakuumpumpe, welche bewirkt, daß die reaktiven Gase in das genannte versiegelte Rohr fließen, um zur erlauben, daß die reaktiven Gase eine chemische Reaktion in der Nähe der Vielzahl von Halbleiter-Wafern durchführen, welche quer bezüglich des genannten Rohres so angeordnet sind, daß sie senkrecht zu oder geneigt zu der Achse des genannten Rohres sind und unter vorbestimmten Abständen voneinander angeordnet sind, mit Regulierung der Zuführung der genannten reaktiven Gase, gekennzeichnet durch die folgenden Schritte:

(a) Anordnung einer Vielzahl von Halbleiter-Wafern in dem versiegelten Rohr, angeordnet quer bezüglich des gesamten Rohres derart, daß sie senkrecht zu oder geneigt zu der Achse des genannten Rohres und mit vorbestimmten Abständen voneinander angeordnet sind,

(b) Fluten nichtreaktiven Gases durch an dem versiegelten Rohr angeordnete Einlässe in das versiegelte Rohr und durch einen Auslaß aus diesem heraus, und Verwendung einer Vakuumpumpe, um zu bewirken, daß das nichtreaktive Gas durch das versiegelte Rohr strömt.

(c) Eichen von Drucküberwachungseinrichtungen, welche an dem Rohr vorgesehen sind, um den internen Druck des genannten Rohres zu überwachen, um den Durchfluß in Termen von Gasgeschwindigkeit bei einer Position zwischen der Peripherie eines ersten

der vielen Halbleiter-Wafer und der angrenzenden inneren Oberfläche des versiegelten Rohres in Richtung des Gasstromes in dem genannten Rohr des nichtreaktiven Gases anzuzeigen,

(d) Fluten reaktiver Gase in und aus das versiegelte Rohr durch die Einlaßöffnungen und eine Auslaßöffnung, welche an dem versiegelten Rohr angeordnet sind, und Verwendung einer Vakuumpumpe, um zu bewirken, daß die reaktiven Gase eine chemische Reaktion in der Nähe der Vielzahl von Halbleiter-Wafern durchführen,

(e) Steuern der Gasgeschwindigkeit der genannten reaktiven Gase, wie es durch die Drucküberwachungseinrichtungen angezeigt wird, um in den Bereich von 6 m pro Sekunde bis 12 m pro Sekunde zu fallen, um eine gleichmäßige Abscheidung von Silikatglas, welches auf der Vielzahl von Halbleiter-Wafern gebildet werden soll, zu erhalten.

3. Verfahren nach Anspruch 1 oder 2, bei welchem die genannten Drucküberwachungseinrichtungen ein Manometer auf dem genannten Rohr in der Nähe der genannten Einlässe umfassen.

4. Verfahren nach einem der vorhergehenden Ansprüche, bei welchem das Silikatglas Phosphorsilikatglas ist.

5. Verfahren nach einem der vorhergehenden Ansprüche, bei welchem der innere Druck des genannten Rohres durch die genannte Vakuumpumpe eingestellt wird, um eine gewünschte Gasgeschwindigkeit der reaktiven Gase zu erreichen.

6. Verfahren nach einem der vorhergehenden Ansprüche; bei welchem die genannte Vielzahl von Wafern innerhalb einer intern gleichmäßig aufgeheizten Temperaturzone, welche in dem genannten Rohr aufrechterhalten wird, angeordnet sind.

7. Verfahren nach einem der vorhergehenden Ansprüche, bei welchem wenigstens einer der Einlässe, die auf dem versiegelten Rohr angeordnet sind, längs der Vielzahl von Halbleiter-Wafern angeordnet ist.

8. Verfahren nach Anspruch 7, bei welchem wenigstens ein Einlaß Sauerstoff als reaktives Gas führt.

## Revendications

1. Procédé de dèpôt de vapeur chimique pour la croissance de couches de verre au silicate sur plusieurs plaquettes semi-conductrices, en utilisant un tube scellé, des entrées et une sortie disposées sur ledit tube scellé pour permettre que des gaz réactifs pénètrent et sortent dudit tube, et une pompe à vide pour que lesdits gaz réactifs circulent dans ledit tube scellé pour permettre que lesdits gaz réactifs produisent une réaction chimique de voisinage desdites plusieurs plaquettes semi-conductrices, les plaquettes étant alignées transversalement par rapport audit tube de manière qu'elles soient perpendiculaires inclinées par rapport à l'axe dudit tube, et étant espacées à des intervalles prédéterminés, le procédé consistant à régler la fourniture des gaz réactifs, procédé caractérisé en ce que le débit desdits gas réactifs, exprimé en vitesse des gaz dans une position entre la périphérie d'une première desdites plusieurs plaquettes semiconductrices et la surface intérieure voisine du tube scellé dans la direction de circulation du gaz dans ledit tube est réglé pour se situer dans la plage de 6 m/sec à 12 m/sec en utilisant un dispositif de contrôle de pression agencé pour contrôler la pression intérieure dudit tube scellé, ce dispositif étant étalonné à l'avance pour indiquer le débit exprimé en vitesse du vaz non réactif.

2. Procédé de dépôt de vapeur chimique pour la croissance de couches de verre au silicate pour plusieurs plaquettes semi-conductrices, en utilisant un tube scellé, des entrées et une sortie disposées sur ledit tube scellé pour permettre que des gaz réactifs pénètrent et sortent dudit tube scellé, et une pompe à vide pour que lesdits gaz réactifs circulent dans ledit tube scellé pour permettre que lesdits gaz réactifs entrent en réaction chimique dans le voisinage desdites plusieurs plaquettes semiconductrices, les plaquettes étant alignées transversalement par rapport audit tube de manière qu'elles soient perpendiculaires ou inclinées par rapport à l'axe dudit tube, et étant espacées à des intervalles prédéterminés, le procédé consistant à régler la fourniture des gaz réactitfs, procédé caractérisé en ce qu'il consiste en outre:

(a) à disposer lesdites plusieurs plaquettes semi-conductrices dans le tube scellé, alignées transversalement par rapport audit tube de manière qu'elles soient perpendiculaires ou inclinées par rapport à l'axe dudit tube et espacées d'intervalles prédéterminés;

(b) à faire circuler un gaz non réactif vers et depuis le tube scellé par des entrées et une sortie disposées sur le tube scellé et en utilisant une pompe à vide pour que le gaz non réactif circule par le tube scellé'

(c) à étalonner le dispositif de contrôle de pression prévu sur ledit tube pour contrôler la pression intérieure dudit tube afin d'indiquer un débit exprimé en vitesse du gaz dans une position entre la périphérie d'une première desdites plusieurs plaquettes semiconductrices et la surface intérieure voisine du tube scellé, dans la direction du débit dans ledit tube du gaz non réactif;

(d) à faire circuler des gaz réactifs vers et depuis le tube scellé par les entrées et la sortie disposées sur le tube scellé et en utilisant une pompe à vide pour que les gaz réactifs entrent en réaction chimique dans le voisinage desdites plusieurs plaquettes semiconductrices;

(e) à régler la vitesse desdits gas réactifs indiquée par le dispositif de contrôle de pression pour qu'elle se situe dans la plage 6 m/sec à

12 m/sec pour obtenir un dépôt uniforme de verre au silicate, formé par lesdites plusieurs plaquettes semi-conductrices.

3. Procédé selon la revendication 1 ou 2, dans lequel ledit dispositif de contrôle de pression consiste en un manomètre sur ledit tube, dans le voisinage desdites entrées.

4. Procédé selon l'une des revendications précédentes, dans lequel le verre au silicate est un verre au phospho-silicate.

5. Procédé selon l'une quelconque des revendications précédentes, dans lequel la pression intérieure dudit tube est réglée par ladite pompe à vide pour obtenir une vitesse voulue des gaz réactifs.

6. Procédé selon l'une quelconque des revendications précédentes, dans lequel lesdites plusieurs plaquettes sont montées dans une zone intérieure de température uniforme maintenue dans ledit tube.

7. Procédé selon l'une des revendications précédentes, dans lequel l'une au moins de entrées disposées sur ledit tube scellé est positionnée le long desdites plusieurs plaquettes semi-conductrices.

8. Procédé selon la revendication 7, dans lequel ladite au moins une entrée conduit l'oxygène comme un gaz réactif.

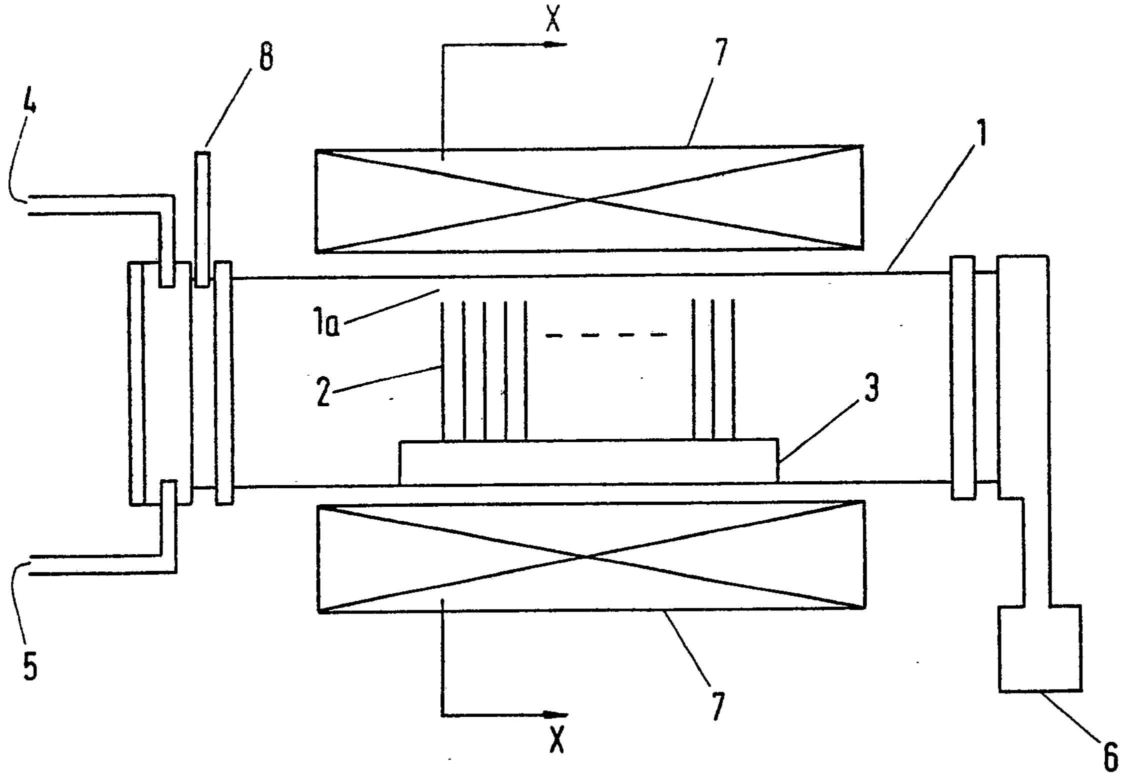


FIG. 1

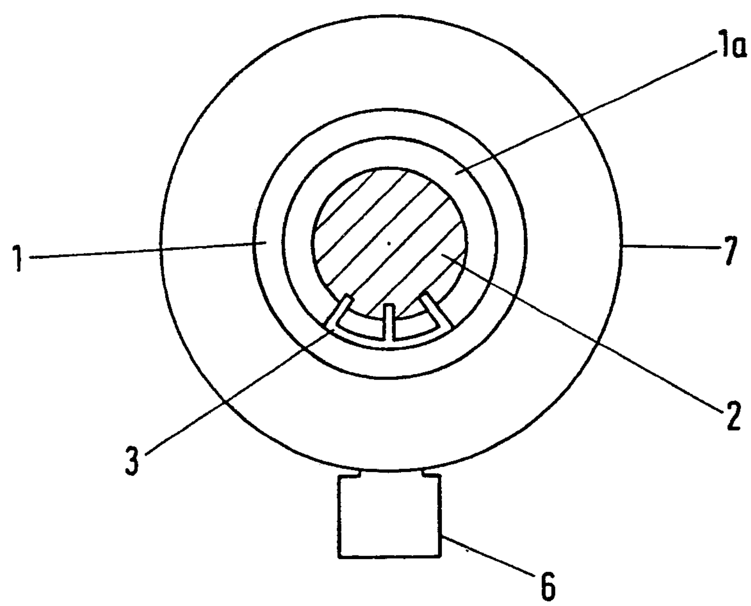


FIG. 2

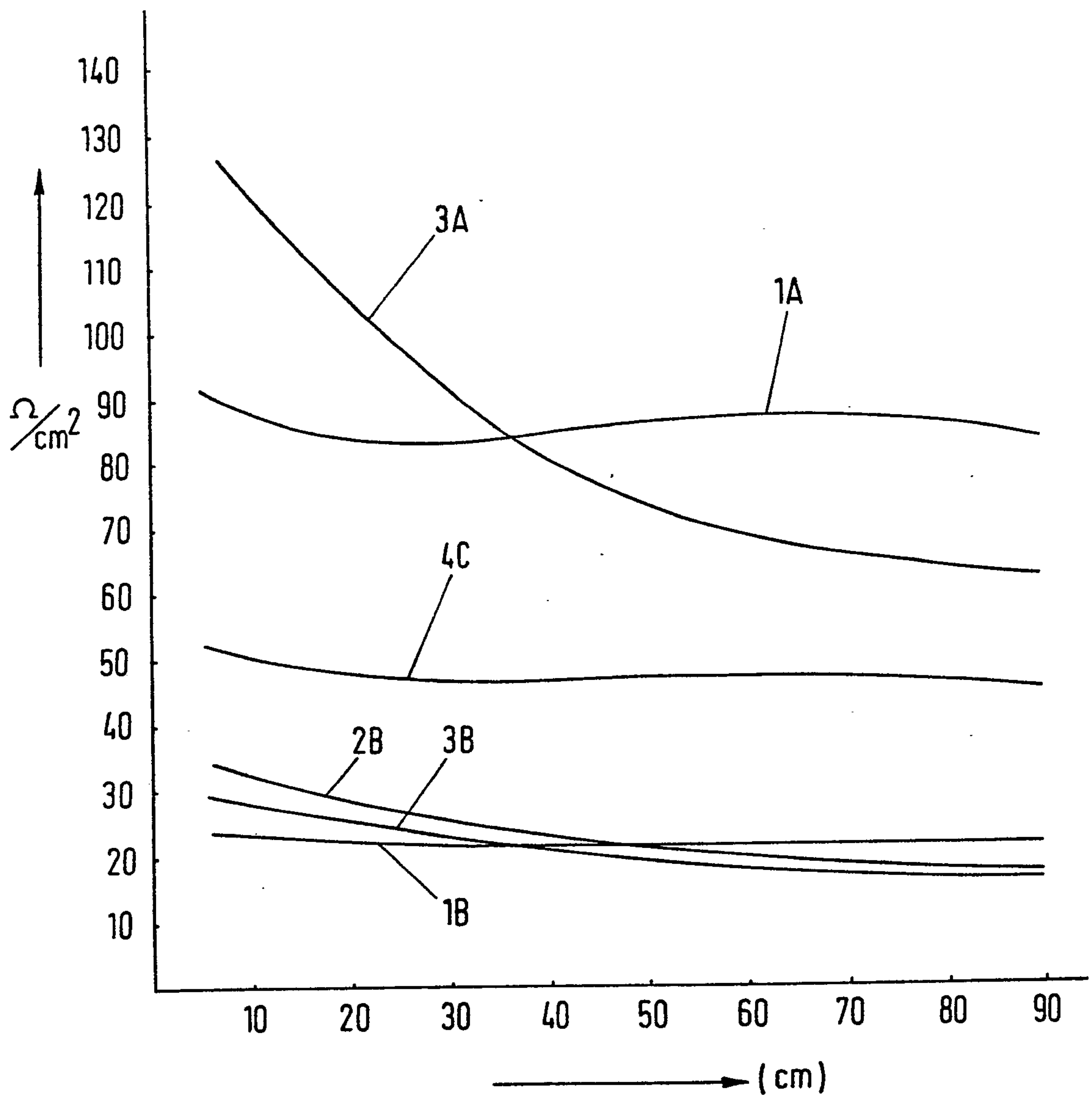
140
130
120
110
100
90
80
70
60
50
40
30
20
10
Ω/cm2
3A
1A
4C
2B
3B
1B
10
20
30
40
50
60
70
80
90
(cm)

FIG. 3